# EUROPÄISCHE PATENTSCHRIFT

(11) **EP 1 985 163 B1**
(45) Veröffentlichungstag und Bekanntmachung des Hinweises auf die Patenterteilung: **27.04.2016**
(21) Anmeldenummer: 07702782.9
(22) Anmeldetag: 16.01.2007
(51) Int. Cl.: H05K 3/00, H05K 1/00

(54) **BIEGBARE LEITERPLATTE MIT ZUSÄTZLICHEM FUNKTIONALEM ELEMENT UND EINER KERBFRÄSUNG UND HERSTELLVERFAHREN UND ANWENDUNG**
FLEXIBLE PRINTED CIRCUIT BOARD WITH ADDITIONAL FUNCTIONAL ELEMENT AND A MILLED NOTCH, METHOD OF PRODUCTION AND USE
CARTE DE CIRCUITS IMPRIMÉS FLEXIBLE COMPORTANT UN ÉLÉMENT FONCTIONNEL SUPPLÉMENTAIRE ET UN RAINURAGE, SON PROCÉDÉ DE PRODUCTION ET SON UTILISATION

(30) Priorität: 31.01.2006 DE 102006004321
(43) Veröffentlichungstag der Anmeldung: 29.10.2008
(73) Patentinhaber: Häusermann GmbH, 3571 Gars am Kamp (AT)
(72) Erfinder: JANESCH, Rudolf, A-3571 Gars am Kamp (AT); STRUMMER, Erich, A-3571 Gars am Kamp (AT); HACKL, Johann, A-3571 Gars am Kamp (AT)
(74) Vertreter: Riebling, Peter
(86) Internationale Anmeldenummer: PCT/EP2007/000318
(87) Internationale Veröffentlichungsnummer: WO 2007/087981

(56) Entgegenhaltungen:
- EP-A- 0 477 981
- DE-A1- 4 412 278
- DE-A1- 19 634 371
- JP-A- 9 129 993
- US-A- 5 903 440

## Beschreibung

Die Erfindung bezieht sich auf eine multifunktionelle Leiterplatte mit zumindest einem zusätzlichen funktionellen Element, wobei die Leiterplatte im Bereich dieses Elementes eine Kerbfräsung aufweist und derart im Sinne einer starr-flexiblen beziehungsweise semi-flexiblen Leiterplatte gebogen werden kann. Die multifunktionelle Leiterplatte kann dabei eine durchkontaktierte Leiterplatte beziehungsweise eine Multilayerleiterplatte beziehungsweise eine flexible Leiterplatte sein.

In der EP01004226B1 wird ein Verfahren zur Herstellung von drahtgeschriebenen Leiterplatten durch partielles Einfüllen einer härtbaren Isoliermasse in eine oben offene Gießform genannt, was in der vorliegenden Erfindung in keiner Weise vonnöten ist.

In der WO02067642A1 wird ein Verfahren zur Herstellung einer Multiwire-Leiterplatte genannt, bei dem auf einer Seite eines dünnen Flächenelementes aus elektrisch leitendem Material mittels voneinander beabstandeter Klebeflächen Leitungsdrähte definiert verlegt und an vorgegebenen Kontaktstellen des Flächenelementes elektrisch mittels Schweißen, Bonden, Löten, Leitkleben o.dgl. (Seite 11, Zeile 5) kontaktiert werden.

DE 44 12 278 A1 offenbart einer starre und flexibele Bereiche aufweisenden Leiterplatte.

Weiters wird auf den fixierten Leitungsdrähten ein mechanisches Stabilisierungselement in Form eines Prepregs oder in Form eines mittels Isolierfolie aufgebrachten, elektrisch leitenden oder isolierenden Flächenelementes vorgesehen.

Das Flächenelement wird dabei von der anderen Seite her derart strukturiert, dass die Kontaktstellen vom übrigen Flächenelement getrennt werden. In dieser WO02067642A1 werden demzufolge Leitungsdrähte mittels Klebeflächen definiert verlegt, was in der vorliegenden Erfindung nicht erforderlich ist, da die Fixierung mittels Reibschweißen beziehungsweise Ultraschall flächig erfolgt.

In den Schriften
AIT EP00405482B1 Improved wire scribed circuit boards and methods of their manufacture,
AIT EP01145609B1 Improved methods for wire-scribing flament circuit patterns with planar and non-planar portions,
Amatech EP00700575B1 Winding head,
Augat EP00141748B1 Wiring system employing wire mat,
Fujikura US06810580B2 System for forming conductor wire on a substrate board,
Fujikura US24074086A1 Method for forming conductor wire on a substrate board,
Hitachi US05584121 Process for producing multiple wire wiring board,
werden weitere Methoden und Verfahren zur Herstellung von drahtgeschriebenen Leiterplatten genannt, jedoch in keiner Weise auf Basis der Methode der vorliegenden Erfindung mittels Reibschweißen oder Ultraschall auf einer Leiterbahnstruktur beziehungsweise auf einer Kupferfolie, die im Anschluss an einen nach dem Stand der Technik erfolgten Pressvorgang in einer Laminierpresse nach dem Stand der Technik mit Leiterstrukturen versehen wird.

Aufgabe der vorliegenden Erfindung ist die kostengünstige Herstellung von multifunktionellen Leiterplatten zur Verdrahtung von hochkomplexen Leiterstrukturen, insbesondere Fein- bis Feinstleiterstrukturen, gemeinsam mit der Möglichkeit des Biegens beziehungsweise Faltens der Leiterplatte.

Dieses Ziel wird durch das Anbringen von funktionellen Elementen mittels Reibschweißen beziehungsweise Ultraschall auf eine Kupferoberfläche der äußeren Lagen einer Leiterplatte und/oder in einer inneren Lage einer noch nicht strukturierten Kupferfolie und/oder einer bereits strukturierten Leiterplatte erreicht. Es findet anschließend ein einebnenden Prozess in Form einer Beschichtung und/oder einer Lamination statt und es wird im Bereich der Biegung eine Kerbfräsung beziehungsweise Kavität ausgebildet, sodass das zumindest eine funktionelle Element als Biegescharnier arbeitet.

Vorteil der Erfindung ist, dass man nun mit Hilfe eines in der Dicke verstärkten, elektrisch leitfähigen Leiterbahnabschnittes gleichzeitig eine Biegekante im Bereich einer in sich starren Leiterplatte bildet. Dies hat einen wesentlichen Vorteil gegenüber den bekannten Ausführungen, welche flexible Leiterplatten beschreiben. Solche flexiblen Leiterplatten sind nur schwer zu bestücken und teuer in der Herstellung und Verarbeitung.

Bei der Wahl einer in sich starren Leiterplatte ist es jedoch ggf. erforderlich, diese Leiterplatte im gebogenen oder gefalteten Zustand in engen Einbauräumen einzubauen. Hier setzt die Erfindung ein, die vorsieht, dass die Biegekante durch in der Dicke verstärkt ausgebildete Leiterbahnabschnitte gebildet wird, um zu erreichen, dass einerseits eine stabile und bruchfeste Biegekante gebildet wird und andererseits hohe Stromquerschnitte in diesem Bereich möglich sind.

Damit ergibt sich der weitere Vorteil, dass es nun erstmals möglich ist, eine solche starre Leiterplatte ein oder mehrfach biegbar auszugestalten, wobei allerdings die Biegewiederholbarkeit auf einige Zyklen beschränkt ist. Dies reicht jedoch für einen einmaligen Einbau in einen beschränkten Einbauraum ohne weiteres aus.

Voraussetzung für den elektrisch leitfähigen Anschluss des in der Dicke vergrößert ausgebildeten Leiterbahnabschnittes - der die Biegekante bildet - zu den übrigen Leiterbahnabschnitten , ist eine qualitativ hochwertige elektrische Kontaktierung.

Hier sieht die Erfindung in einem bevorzugten Ausführungsbeispiel eine sogenannte Reibschweiß- oder Ultraschall-Schweißverbindung zur Ausbildung einer intermetallischen Verbindung zwischen den auf der Leiterplatte angeordneten Leiterbahnabschnitten mit geringer Dicke und der elektrisch daran anschließenden Leiterbahn großer Dicke vor.

In einer bevorzugten Ausgestaltung der Erfindung kann die Biegekante der Leiterplatte durch eine querschnittsschwächende Kerbfräsung oder einer anderen querschnittsschwächenden Maßnahme eingebracht werden. Solche querschnittsschwächenden Maßnahmen, die sich über die gesamte Breite der Leiterplatte erstrecken, sind beispielsweise Einritzen, Fräsen, Kerben, Laser-Ritzen und dergleichen Behandlungsvorgänge mehr.

Bei allen Ausführungsformen kann es vorgesehen sein, dass im Bereich der Biegekante des elektrisch leitfähigen Leiterbahnabschnittes noch Kunststoffmaterial der Leiterplatte stehen bleibt oder - in einer anderen Ausgestaltung - dass dieses Kunststoffmaterial vollständig entfällt.

Die Biegekante ist dann allein durch diesen elektrisch leitfähigen Leiterbahnabschnitt gebildet.

Es ist im übrigen vorteilhaft, im Bereich der Biegekante groß profilierte Leiterbahnabschnitte mit einer gegenüber der Dicke der übrigen Leiterbahnabschnitten vergrößerten Dicke zu verwenden, weil in diesem Bereich eine besonders gute Wärmeableitung gegeben ist. Nachdem dieser Leiterbahnabschnitt vergrößerter Dicke im Biegungsbereich liegt (die Biegekante bildet), ist aufgrund der freiliegenden Abschnitte eine besonders gute Wärmeableitung gegeben.

Selbstverständlich sieht die vorliegende Erfindung vor, dass nicht nur eine sich über die Breite der Leiterplatte erstreckende Biegekante vorgesehen ist, sondern es können in einer Leiterplatte auch mehrere und ggf. im Winkel zueinander stehende und räumlich voneinander getrennte Biegekanten vorgesehen sein.

Auf diese Weise kann eine an sich starre Leiterplatte mehrfach zusammengefaltet werden und die entsprechenden Biegekanten sind dann stets erfindungsgemäß durch die Leiterbahnabschnitte vergrößerter Dicke ausgebildet.

In einer Weiterbildung der Erfindung können derartige funktionelle Elemente als selektive wärmeableitende und als selektiv hohe Ströme führende Elemente verwendet werden.

Das zumindest eine funktionelle Element wird mittels Ultraschall beziehungsweise mittels Reibschweißen zumindest stückweise flächig auf eine Kupferfolie durch Bildung einer intermetallischen Verbindung befestigt. Bei Anbringung von zwei Kerbfräsungen nebeneinander im Bereich von einem funktionellen Element kann die Leiterplatte durch zweimalige Biegung um je etwa 45° um insgesamt 90° und darüber gebogen werden.

Die Kerbfräsung kann dabei mit einem Winkel von 0° bis etwa 45° ausgeführt werden und die Tiefe der Kerbfräsung kann bis auf die Oberfläche des funktionellen Elementes ausgeführt werden beziehungsweise es können noch einige 10 bis einige 100 µm des entsprechenden Basismaterials auf der Oberfläche des Elementes belassen werden.

Übliche Leiterplatten werden mittels Ätztechnik, also mittels einer Subtraktivtechnik, hergestellt. Dabei begrenzt im Wesentlichen die jeweils verwendete Kupferfolienstärke von typisch 35 µm oder der halben beziehungsweise der doppelten Dicke und die Strukturbreite die Strombelastbarkeit der Leiterbahnen und deren thermisches Leitvermögen.

Durch die Kombination einer herkömmlichen, ätztechnisch strukturierten Verdrahtungsebene mit wenigen additiven, zusätzlichen Verdrahtungselementen kann so eine sehr kostengünstig herstellbare multifunktionale Leiterplatte gestaltet werden, die zusätzlich zu der üblicherweise komplexen Schaltungslogik eine entsprechend stromführende Verdrahtung integriert.
Diese stromführende Verdrahtung weist wesentlich dickere Strukturen auf und wird selektiv für zusätzliche wärmeableitende Funktionen verwendet.

Mit der Ausbildung von Kavitäten beziehungsweise Kerbfräsungen kann sie auch gebogen, beziehungsweise geknickt, beziehungsweise gefaltet werden. Auf diese Weise wird eine Art starr-flexible beziehungsweise semi-flexible Leiterplatte gebildet. Für die Verwendung als Biegescharnier muß überdies das zusätzliche funktionelle Element nicht unbedingt elektrisch leitfähig ausgebildet sein, sondern es muss gut mittels Ultraschall beziehungsweise Reibschweißtechnik auf einer Kupferfolie zumindest stückweise flächig appliziert werden können und muß die erforderlichen Biegeeigenschaften aufweisen.

In einer ersten Ausführungsvariante werden funktionelle Elemente mittels Reibschweißverfahren oder Ultraschallschweißverfahren bevorzugt flächig auf eine darunter befindlichen ätztechnisch hergestellten Leiterstruktur befestigt und anschließend mittels entsprechender Harzsysteme einebnend bearbeitet.

In einer zweiten Ausführungsvariante werden funktionelle Elemente mittels Reibschweißen beziehungsweise Ultraschall selektiv elektrisch isolierend auf einem Leiterplattensubstrat befestigt. Dabei kann die Isolationsschicht vollflächig oder selektiv auf der entsprechenden Leiterplattenoberfläche angeordnet sein oder es kann das elektrisch leitfähige Verdrahtungselement auf der entsprechenden Seite oder umhüllend mit einem entsprechenden Harz versehen sein. Derart kann eine eigenständige Verdrahtungsebene hergestellt werden. Die anschließende Einebnung mittels geeigneter Harzsysteme kann wie in der ersten Ausführungsvariante erfolgen.

In einer weiteren Ausbildung der vorliegenden Erfindung werden insbesondere flache, funktionelle Elemente als selektive Biegeelemente verwendet. Dabei können flächige Elemente in einer Innenlage oder auf einer der beiden Oberflächen positioniert werden und es wird im Anschluss an die Einebnung beziehungsweise Lamination eine Öffnung beziehungsweise Kavität beziehungsweise Kerbfräsung derart hergestellt, dass eine Biegung um zum Beispiel 45° oder 90° oder darüber möglich wird.

Die Öffnung wird mit einem entsprechenden Fräs- oder Ritzvorgang mittels mechanischer Werkzeuge oder mittels Laser derart selektiv vorgenommen, dass dieses zumindest eine flächige Element im weitgehend freigelegten Bereich biegbar ist und so eine semiflexible Leiterplatte beziehungsweise eine biegbare Leiterplatte gegeben ist.

Unter einem funktionellen Elemente wird in dieser Erfindung zumindest ein flächiges gut biegbares Element verstanden, insbesondere werden darunter stückweise Elemente in Form von Runddraht oder Flachdraht verstanden, wobei als Material Kupfer oder Aluminium oder eine elektrisch gut leitfähige und biegbare und kontaktierbare Legierung verwendet wird.

Für die Verwendung als Biegeelement beziehungsweise eines thermisch gut leitfähigen Elementes werden ebenfalls diese Materialien wie auch elektrisch isolierende Materialien verwendet.

Im Fall der Verwendung dieses Elementes als Biegeelement können alle genannten Materialien und zusätzlich gut verarbeitbare, flächige Materialien verwendet werden, die ausreichend stabil für die jeweils geforderte Biegewechselzahl sind. Derartige Rund- oder Flachdrähte können überdies isolierend oder passivierend oder haftvermittelnd beschichtet ausgeführt werden.

Es wird ferner ein kostengünstiges Verfahren zur Herstellung einer Leiterplatte mit zusätzlichen funktionalen Elementen beschrieben. Dabei werden insbesonders runde beziehungsweise rechteckige gut biegbare Elemente beziehungsweise optional elektrisch leitfähige Verdrahtungselemente oder thermisch gut leitfähige flächige Elemente mittels Reibschweißen oder Ultraschall auf eine oder beide Oberflächen und/oder in einer inneren Lage einer Leiterplatte angeordnet und es wird anschließend ein einebnender Prozess in Form einer Beschichtung und/oder einer Lamination ausgeführt.

Es wird ferner die Anwendung einer derartigen Leiterplatte mit zusätzlichen funktionalen Elementen als multifunktionelle Leiterplatte für die Herstellung von semiflexiblen bis starr-flexiblen Leiterplatten beschrieben. Der große Vorteil liegt dabei darin, dass mehrere Leiterplatten inklusive der notwendigen Steckverbindungen durch eine einzige Leiterplatte ersetzt werden und dabei eine Mehrzahl von Biegeelementen verwendet werden, die in der Lage sind, hohe Ströme zu leiten. Ferner können derartige Elemente an eine Kante oder Kontaktierstelle einer Leiterplatte geführt und dort sehr effizient ein Anschluß für die Beaufschlagung mit hohen Strömen hergestellt werden.

Alle in den Unterlagen, einschließlich der Zusammenfassung offenbarten Angaben und Merkmale, insbesondere die in den Zeichnungen dargestellte Ausbildung, werden als erfindungswesentlich beansprucht, soweit sie einzeln oder in Kombination gegenüber dem Stand der Technik neu sind.

Die Erfindung wird nun anhand mehrerer Ausführungsbeispiele näher beschrieben. Hierbei gehen aus den Zeichnungen und ihrer Beschreibung weitere Vorteile und Merkmale hervor.

Einige Ausführungsbeispiele der Erfindung werden nachfolgend anhand der Zeichnungsfiguren näher beschrieben.

Dabei zeigt:
**Figur 1****:** eine schematische Darstellung einer multifunktionellen Leiterplatte (1) mit einem funktionellen Element (3) in einer einfachen Ausführungsform im Schnitt,
**Figur 2a****:** eine schematische Darstellung einer multifunktionellen Leiterplatte (1) mit einem funktionellen Element (3) in einer Innenlage im Schnitt,
**Figur 2b****:** eine schematische Darstellung einer multifunktionellen Leiterplatte (1) mit vier funktionellen Elementen (3) in einer Innenlage in Draufsicht ohne Lötstoppmaske (13, 14),
**Figur 2c****:** eine schematische Darstellung einer multifunktionellen Leiterplatte (1) mit vier funktionellen Elementen (3) in einer Innenlage in Draufsicht mit Lötstoppmaske (13, 14),
**Figur 3****:** eine schematische Darstellung einer erfindungsgemäßen multifunktionellen Leiterplatte (1) mit einem funktionellen Elementen (3) und zwei Kerbfräsungen (21, 22) im Schnitt.
**Figur 4****:** eine schematische Darstellung einer erfindungsgemäßen multifunktionellen Leiterplatte (1) mit einem funktionellen Elementen (3) und zwei Kerbfräsungen (21, 22) im Schnitt und in gebogener Ausführung.

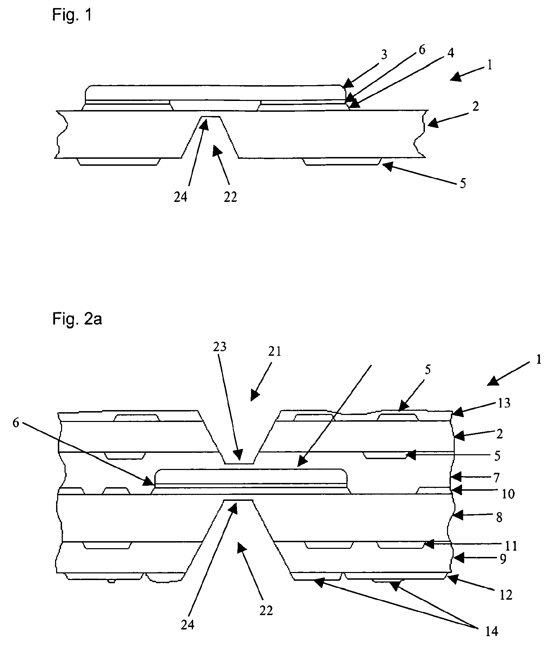

In **Figur 1** wird eine schematische Darstellung einer multifunktionellen Leiterplatte (1) mit einem funktionellen Element (3) in einer einfachen Ausführungsform im Schnitt gezeigt.

In dieser einfachen Ausführungsform wird ein Substrat (2) aus einem üblichen Leiterplattenmaterial wie FR-2, FR-3, FR-4, FR-4-Low-Tg, CEM-1, CEM-x, PI, CE, Aramid und dergleichen Substratmaterialien mit beidseitig hergestellter Leiterbahnstruktur (4, 5) verwendet und es wird ein funktionelles Element (3) flächig mittels Ultraschall beziehungsweise einem Reibschweißvorgang auf die zwei gezeichneten Leiterbahnstrukturen (4) kontaktiert.

In diesem Ausführungsbeispiel wird von unten eine Kerbfräsung (22) ausgeführt. Die Flanken können dabei von wenigen Winkelgraden bis 90° ausgeführt werden und die Kerbtiefe (24) kann bis direkt zum Element (3) ausgeführt werden, oder es kann noch ein Reststeg belassen werden.

In einer ersten Ausführungsform kann dabei das funktionelle Element (3) aus Kupfer oder Aluminium verwendet werden und es wird dabei üblicherweise mit der aus Kupfer bestehende Leiterbahnstruktur (4) eine intermetallische Verbindung hergestellt.

In weiteren Ausbildungen der vorliegenden Erfindung können die Oberflächen der Kontaktpaare (3, 4) chemisch oder galvanisch oder mittels Heißverzinnung (HAL) beschichtet sein. Bei entsprechender Materialpaarung wird bei einem üblichen Frequenzbereich von einigen kHz bis über 30 kHz Ultraschallenergie und bei entsprechender Sonotrodenausbildung und bei entsprechendem Anpressdruck eine flächige intermetallische Verbindung hergestellt, wobei lediglich in einem wenige µm-Tiefe umfassenden Kontaktbereich eine für die Ausbildung des intermetallischen Kontaktes erforderliche hohe Temperatur erreicht wird.

Insgesamt erfährt das gesamte System örtlich dadurch keine große Erwärmung und es treten verglichen mit Punktschweiß-Verbindungen nahezu keine Thermospannungen au, so dass die Verbindungspartner auch nach dem Verbindungsvorgang eine plane Lage aufweisen.

Bei Verwendung von lackisolierten, funktionellen Elementen (3) kann bei spezieller Ausbildung der Kontaktpartner (3, 4) und bei entsprechender Ausbildung der Lackschicht eine intermetallische Kontaktschicht (6) erreicht werden. Es können jedoch auch die Kontaktflächen mechanisch und/oder chemisch von einer allfälligen Isolationsschicht befreit werden. Dabei können Schleifverfahren, Bürstverfahren, Fräsverfahren oder ein Ätzverfahren oder ein Plasmaverfahren oder ein UV-Laserverfahren verwendet werden.

In der vorliegenden Figur 1 wird das funktionelle Element (3) als Verbindungselement zwischen zwei Elementen der Leiterbahnstruktur (4) dargestellt. Grundsätzlich können noch weitere Leiterbahnstrukturen (4) kontaktiert werden und/oder es können auch weitere Leiterbahnstrukturen (4) unterhalb des funktionellen Elementes (3) angeordnet werden. Dabei können derartige Elemente mit einer isolierenden, polymeren Schicht abgedeckt werden oder es kann das funktionelle Element (3) in derartigen Bereichen isolierend ausgebildet werden. Derart können Überkreuzungen ausgebildet werden.

In einer weiteren Ausbildung der vorliegenden Erfindung kann das funktionelle Element (3) als Stückelement mit der gewünschten geometrischen Abmessung verwendet werden oder das Element (3) kann von einer Rolle zugeführt und gegebenenfalls durch eine geeignete Ausbildung der Sonotrode beim Kontaktiervorgang abgelängt werden.

Optionell kann im Anschluß an den Kontaktier- und Verlegevorgang noch ein Kalandriervorgang in Form von Kalander-Rollen oder einer Flachpressvorgang ausgeführt werden und so die Planlage bei kritischen Produkten erhöht werden.

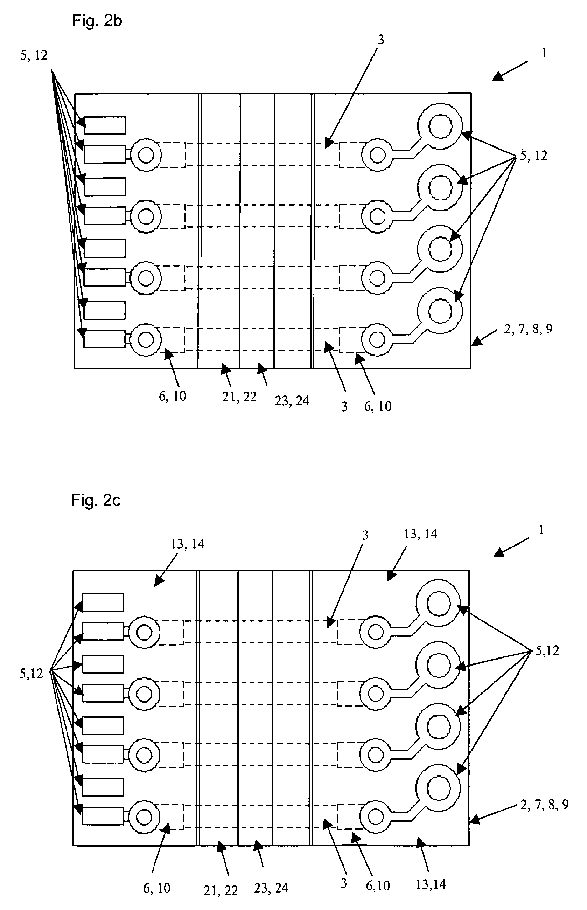

In **Figur 2a** wird eine schematische Darstellung einer multifunktionellen Leiterplatte (1) mit einem funktionellen Element (3) in einer Innenlage (7) im Schnitt aufgezeigt. Das Substrat (7) wird für die Einbettung beim Laminiervorgang verwendet, sodass eine weitgehend gleich dicke und ebene Leiterplatte (1) erreicht wird. In dieser Figur 2 wird lediglich ein funktionelles Element (3) über einem Element einer Verdrahtungsstruktur (10) mit der intermetallischen Verbindungsschicht (6) dargestellt. Ähnlich wie in Figur 1 schematisch dargstellt, kann das funktionelle Element (3) auch Leiterbahnstrukturen überkreuzen und es können Elemente (3) auch in den Substratebenen (2, 8, 9) angeordnet werden, beziehungsweise auf den Leiterbahnstrukturen (4, 5, 10, 11, 12). Die Kontaktierung derartiger funktionaler Elemente (3) kann über Durchsteigelöcher beziehungsweise Sacklöcher auf eine Kontaktfläche (4, 12) erfolgen oder durch Freifräsung oder Laserung.

In Figur 2b wird eine schematische Darstellung einer multifunktionellen Leiterplatte (1) mit vier funktionellen Elementen (3) in einer Innenlage in Draufsicht ohne Lötstoppmaske (13, 14) aufgezeigt. Die Anschlusselemente (5, 12) können in Form von rasterartigen, flächigen Kontaktelementen bis zu Lötring-artigen Kontaktflächen bis zu verschraubbaren oder Klemmbaren Kontaktelementen ausgebildet werden.

Die Elemente (3) werden derart ausgebildet, dass sie im Bereich der Biegestelle (23, 24) mehrfach biegbar ausgebildet sind. Es können mehrere sogenannte Kerbfräsungen (23, 24) oder Ritzungen oder Nutfräsungen oder Laserablationslinien ausgeführt werden und derart Biegungen bis zu 180° ausgebildet werden.

In **Figur 2c** wird eine schematische Darstellung einer multifunktionellen Leiterplatte (1) mit vier funktionellen Elementen (3) in einer Innenlage in Draufsicht mit Lötstoppmaske (13, 14) aufgezeigt. Die Lötstoppmaske (13, 14) bedeckt üblicherweise sämtliche Oberflächenelemente einer Leiterplatte, die nicht für Kontaktierungszwecke vorgesehen sind. Auf diese Weise wird eine Isolation oder Passivierung erreicht und eine geometrische Maskierung für Lötprozesse beziehungsweise chemische oder galvanische Prozesse gewährleistet.

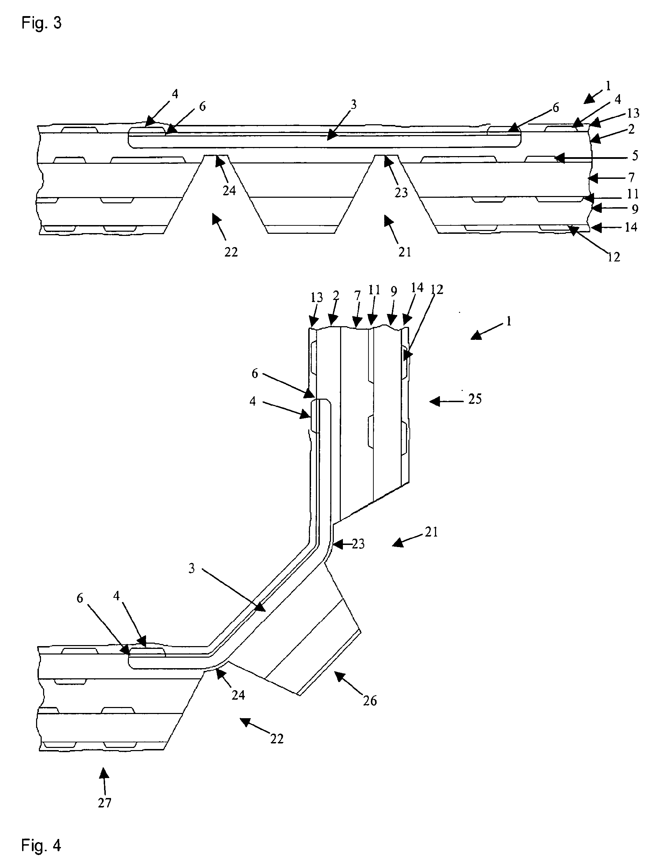

In **Figur 3** ist eine schematische Darstellung einer erfindungsgemäßen multifunktionellen Leiterplatte (1) mit einem funktionellen Elementen (3) und zwei Kerbfräsungen (21, 22) im Schnitt gezeigt.

Die Anordnung ist nur beispielhaft ausgeführt. Es kann ebenso nur eine Kerbfräsung (21) ausgebildet sein oder es können mehr als zwei Kerbfräsungen (21, 22) ausgebildet sein. Die Lage des funktionellen Elementes (3) kann des Weiteren nicht innenliegend im Substrat (2) ausgeführt, sondern auf der Oberseite der Leiterbahnstrukturen (4) angeordnet werden oder auf einer der inneren Strukturen (5, 11) oder auch auf der unteren Struktur (12) oder auf nicht gezeichneten weiteren Verdrahtungsebenen einer Multilayerleiterplatte.

Die Kerbfräsungen (21, 22) sind ebenfalls nur beispielhaft mit einem Winkel von etwa 30° gegenüber der Senkrechten eingezeichnet und können mit nahezu 0° bis etwa 45° ausgebildet sein. Dabei spielt das Herstellverfahren dieser als Kerbfräsung (21, 22) bezeichneten Öffnung beziehungsweise Kavität eine Rolle. Bei Verwendung mechanischer Fräswerkzeuge mit 60°kann eine Kerbfräsung (21, 22), wie abgebildet, sehr einfach hergestellt werden. Bei Verwendung von NC-gesteuerten Fräsanlagen und Fräswerkzeugen wird bevorzugt ein Winkel um die 0° gewählt und bei Verwendung eines ablatierenden Laserstrahls wird ein dünner Schlitz gewählt.

Die Tiefe (23, 24) der Kerbfräsungen (21, 22) kann dabei unterschiedlich eingestellt werden. Es kann dabei wie in Figur 3 skizziert ein Reststeg auf dem Element (3) belassen werden oder es kann bis auf das Material des Elementes (3) die Öffnung (21, 22) ausgeführt werden. Im Falle der Anfräsung des Elementes (3) kann dieses noch chemisch oder galvanisch oder mittels polymere Beschichtungen passiviert werden.

Das Element (3) dient zumindest stückweise als Biegescharnier und muß auf die Anzahl der geforderten Biegewechselzahlen ausgelegt und dimensioniert sein. Falls zusätzlich eine Stromführung über derartige Biegeelemente (3) erforderlich ist, wird das Scharnier durch eine entsprechende Anzahl an Biegeelementen (3) gebildet.

Die Elemente (3) können natürlich auch derart ausgebildet sein, dass diese an einer Kante der Leiterplatte derart freigelegt werden, dass ein effizienter elektrischer Anschluß möglich ist und auch hohe Ströme bewältigt werden können. Der wesentliche Vorteil einer derartigen Leiterplatte (1) liegt darin, dass dadurch zwei oder drei oder mehrere einzelne Leiterplatten inklusive deren Verbindungselemente durch eine einzige Leiterplatte ersetzt werden können und dass die dazu erforderlichen Prozesse sehr kostengünstig in übliche Leiterplattenfertigungen integriert werden können.

In **Figur 4** wird eine schematische Darstellung einer erfindungsgemäßen multifunktionellen Leiterplatte (1) mit einem funktionellen Elementen (3) und zwei Kerbfräsungen (21, 22) im Schnitt und in gebogener Ausführung aufgezeigt. Dabei wird eine von vielen Möglichkeiten der Formgestaltung einer derartigen multifunktionellen Leiterplatte (1) aufgezeigt. In der skizzierten Ausführungsform werden zwei Kerbfräsungen (21, 22) verwendet und betragen derart die einzelnen Abwinkelungen lediglich 45° und können derart die drei Leiterplattenteile (25, 26, 27) rechtwinkelig gebogen werden.

Die bevorzugten Anwendungen beziehen sich darauf, dass das biegbare Element wahlweise als Biegescharnier und/oder Wärmeableitfläche und/oder stromführendes Element verwendet werden kann. Die oben genannten Alternativen genießen somit jede für sich in Alleinstellung oder in Kombination unter einander Erfindungsschutz. Unter einem "stromführenden" Element wird hierbei wahlweise die Stromführung mit Stromstärken verstanden, die auch auf den dünnen Leiterbahnen der Leiterplatte geführt sind.

Alternativ kann jedoch eine Hochstrom-führende Variante vorgesehen werden, wenn es darum geht, einen höheren Strom, wie er von den dünnen Leiterbahnen der Leiterplatte nicht geführt werden könnte, von der einen Seite der Leiterplatte über das biegbare Element zur anderen Seite der Leiterplatte zu transportieren.

### Bezugszeichenliste

- 1: Multifunktionelle Leiterplatte mit zumindest einem funktionalen Element
- 2: Substrat: Basismaterial z.B. FR-2, FR-3, FR-4, FR-4-Low-Tg, CEM-1, CEM-x, PI, CE, Aramid, usw. bzw. Prepreg
- 3: Funktionales Element: rund oder rechteckig bzw. bandförmig; Kupfer oder Aluminium oder elektrisch u/o thermisch gut leitfähig
- 4: Leiterbahnstruktur: z.B. geätztes Kupfer
- 5: Leiterbahnstruktur Unterseite
- 6: Intermetallische Verbindung: US- bzw. Reibschweißen
- 7: Substrat 2: z.B. Innenlage bzw. Kernlage
- 8: Substrat 3: z.B. Innenlage bzw. Kernlage
- 9: Substrat 4: z.B. Außenlage bzw. Prepreg
- 10: Leiterbahnstruktur innenliegend
- 11: Leiterbahnstruktur innenliegend
- 12: Leiterbahnstruktur außenliegend
- 13: Soldermaske bzw. Lötstopmaske oben
- 14: Soldermaske bzw. Lötstopmaske unten
- 15: Kavität oben
- 16: Bauteil
- 17: Thermische Kontaktierung (inkl. mechanischer Befestigung/Montage)
- 18: Vergußmasse
- 19: Kühlkörper
- 20: Durchkontaktierung bzw. Durchsteigeloch
- 21: Kerbfräsung
- 22: Kerbfräsung
- 23: Tiefe der Kerbfräsung
- 24: Tiefe der Kerbfräsung
- 25: Leiterplattenteil 1
- 26: Leiterplattenteil 2
- 27: Leiterplattenteil 3

## Patentansprüche

1. Multifunktionelle Leiterplatte (1) mit zumindest einem zusätzlichen funktionellen Element (3), wobei im Bereich von zumindest einem funktionellen Element (3) zumindest eine Kerbfräsung (21, 22) angebracht ist und die Leiterplatte (1) mindestens in diesem Bereich biegbar ist, **dadurch gekennzeichnet, dass** das zumindest eine funktionelle Element (3) mittels Ultraschall beziehungsweise mittels Reibschweißen zumindest stückweise flächig auf eine Kupferfolie (4, 5, 10, 11, 12) in einer Innenlage (7) der Leiterplatte (1) mit einer intermetallischen Verbindung (6) befestigt ist.

2. Multifunktionelle Leiterplatte (1) nach Anspruch 1, **dadurch gekennzeichnet, dass** das funktionelle Element (3) mindestens eine Biegekante der Leiterplatte bildet.

3. Multifunktionelle Leiterplatte (1) nach Anspruch 1 oder 2, **dadurch gekennzeichnet, dass** das multifunktionelle Element (3) in seiner Dicke gegenüber den übrigen Leiterbahnabschnitten auf der Leiterplatte verstärkt ausgebildet ist.

4. Multifunktionelle Leiterplatte (1) nach einem der Ansprüche 1 bis 3, **dadurch gekennzeichnet, dass** die multifunktionelle Leiterplatte (1) eine durchkontaktierte Leiterplatte ist beziehungsweise eine Multilayerleiterplatte ist.

5. Multifunktionelle Leiterplatte (1) nach einem der Ansprüche 1 bis 4, **dadurch gekennzeichnet, dass** im Bereich von zumindest einem funktionellen Element (3) zumindest zwei Kerbfräsungen (21, 22) angebracht sind und derart die Leiterplatte (1) durch zweimalige Biegung um etwa 45° um insgesamt 90° gebogen werden kann.

6. Multifunktionelle Leiterplatte (1) nach einem der Ansprüche 1 bis 5, **dadurch gekennzeichnet, dass** die zumindest eine Kerbfräsung (21, 22) mit einem Winkel von 0° bis etwa 45° ausgeführt wird und die Tiefe der Kerbfräsung (23,24) bis auf die Oberfläche des funktionellen Elementes (3) ausgeführt wird beziehungsweise noch einige 10 bis einige 100 µm des entsprechenden Basismaterials (2) auf der Oberfläche des Elementes (3) belässt.

7. Multifunktionelle Leiterplatte (1) nach einem der Ansprüche 1 bis 6, **dadurch gekennzeichnet, dass** das biegbare Element stromführend ist.

8. Multifunktionelle Leiterplatte (1) nach einem der Ansprüche 1 bis 6, **dadurch gekennzeichnet, dass** das biegbare Element isolierend ausgebildet ist.

9. Multifunktionelle Leiterplatte (1) nach einem der Ansprüche 1 bis 8, **dadurch gekennzeichnet, dass** das biegbare Element wärmeableitend ausgebildet ist.

10. **Verfahren** zur Herstellung einer multifunktionelle Leiterplatte (1) mit zumindest einem zusätzlichen funktionellen Element (3), wobei im Bereich des funktionellen Elementes (3) zumindest eine Kerbfräsung (21, 22) angebracht wird und die Leiterplatte (1) in diesem Bereich biegbar ausbildet, **dadurch gekennzeichnet, dass** das zumindest eine funktionelle Element (3) mittels Ultraschall beziehungsweise mittels Reibschweißen in Form einer intermetallischen Verbindung (6) mit einer Kupferfolie (4, 5,10, 11, 12) in einer Innenlage (7) der Leiterplatte (1) zumindest stückweise flächig verbunden ist.

11. **Anwendung** einer multifunktionelle Leiterplatte (1) mit zumindest einem zusätzlichen funktionellen Element (3) nach einem der Ansprüche 1 bis 9 als starr-flexible Leiterplatte (1).

12. Anwendung nach Anspruch 11, **dadurch gekennzeichnet, dass** das biegbare Element als Kühlfläche genutzt ist.

13. Anwendung nach einem der Ansprüche 11 oder 12, **dadurch gekennzeichnet, dass** das biegbare Element als Stromleiter genutzt ist.

14. Anwendung nach einem der Ansprüche 11 oder 13, **dadurch gekennzeichnet, dass** das biegbare Element als Hochstromführender Stromleiter genutzt ist.

## Claims

1. Multi-functional printed circuit board (1) with at least one additional functional element (3), wherein at least one milled notch (21, 22) is formed in the region of at least one functional element (3) and the printed circuit board (1) is bendable at least in this region, **characterised in that** the at least one functional element (3) is fastened flat at least piece by piece by means of ultrasound or by means of friction welding forming an intermetallic bond (6) on a copper foil (4, 5, 10, 11, 12) in an inner layer (7) of the printed circuit board (1).

2. Multi-functional printed circuit board (1) according to claim 1, **characterised in that** the functional element (3) forms at least one bending edge of the printed circuit board.

3. Multi-functional printed circuit board (1) according to claim 1 or 2, **characterised in that** the multi-functional element (3) is formed with its thickness increased compared with the remaining circuit track sections on the printed circuit board.

4. Multi-functional printed circuit board (1) according to one of claims 1 to 3, **characterised in that** the multi-functional printed circuit board (1) is a through-plated printed circuit board or a multi-layer printed circuit board.

5. Multi-functional printed circuit board (1) according to one of claims 1 to 4, **characterised in that** at least two milled notches (21, 22) are formed in the region of at least one functional element (3) and in this way the printed circuit board (1) can be bent through a total of 90° by being bent through approximately 45° twice.

6. Multi-functional printed circuit board (1) according to one of claims 1 to 5, **characterised in that** the at least one milled notch (21, 22) is formed with an angle of from 0° to approximately 45° and the depth of the milled notch (23, 24) is made as far as the surface of the functional element (3) or leaves just a few 10s to a few 100s of µm of the corresponding base material (2) on the surface of the element (3).

7. Multi-functional printed circuit board (1) according to one of claims 1 to 6, **characterised in that** the bendable element is live.

8. Multi-functional printed circuit board (1) according to one of claims 1 to 6, **characterised in that** the bendable element is embodied in the form of an insulator.

9. Multi-functional printed circuit board (1) according to one of claims 1 to 6, **characterised in that** the bendable element is embodied in the form of a heat dissipator.

10. Method for producing a multi-functional printed circuit board (1) with at least one additional functional element (3), wherein at least one milled notch (21, 22) is formed in the region of the functional element (3) and makes the printed circuit board (1) bendable in this region, **characterised in that** the at least one functional element (3) is connected flat at least piece by piece by means of ultrasound or by means of friction welding forming an intermetallic bond (6) with a copper foil (4, 5, 10, 11, 12) in an inner layer (7) of the printed circuit board (1).

11. Use of a multi-functional printed circuit board (1) with at least one additional functional element (3) according to one of claims 1 to 9 as a flexible-rigid printed circuit board (1).

12. Use according to claim 11, **characterised in that** the bendable element is used as a cooling surface.

13. Use according to one of claims 11 or 12, **characterised in that** the bendable element is used as a current conductor.

14. Use according to one of claims 11 or 13, **characterised in that** the bendable element is used as a current conductor carrying high current.

## Revendications

1. Carte de circuits imprimés multifonctionnelle (1) avec au moins un élément fonctionnel supplémentaire (3), étant précisé que dans la zone d'au moins un élément fonctionnel (3) est disposé au moins un rainurage (21, 22) et que ladite carte (1) est flexible au moins dans cette zone, **caractérisée en ce que** l'élément ou les éléments fonctionnels (3) sont fixés par ultrasons ou par soudage par friction, au moins par morceaux, à plat sur un film de cuivre (4, 5, 10, 11, 12) dans une couche intérieure (7) de la carte (1), avec une liaison intermétallique (6).

2. Carte de circuits imprimés multifonctionnelle (1) selon la revendication 1, **caractérisée en ce que** l'élément fonctionnel (3) forme au moins un bord de pliage de la carte de circuits imprimés.

3. Carte de circuits imprimés multifonctionnelle (1) selon la revendication 1 ou 2, **caractérisée en ce que** l'élément multifonctionnel (3) présente une plus grande épaisseur que les autres parties de pistes conductrices sur ladite carte.

4. Carte de circuits imprimés multifonctionnelle (1) selon l'une des revendications 1 à 3, **caractérisée en ce que** la carte de circuits imprimés multifonctionnelle (1) est une carte de circuits imprimés à connexion transversale ou une carte de circuits imprimés multicouche.

5. Carte de circuits imprimés multifonctionnelle (1) selon l'une des revendications 1 à 4, **caractérisée en ce qu'**il est prévu dans la zone d'au moins un élément fonctionnel (3) au moins deux rainurages (21, 22), et que la carte de circuits imprimés (1) peut ainsi être pliée en tout de 90° en étant pliée deux fois d'environ 45°.

6. Carte de circuits imprimés multifonctionnelle (1) selon l'une des revendications 1 à 5, **caractérisée en ce que** le ou les rainurages (21, 22) sont réalisés avec un angle de 0° à environ 45°, et la profondeur du rainurage (23, 24) est réalisée jusqu'à la surface de l'élément fonctionnel (3) ou laisse encore sur la surface de l'élément (3) quelque 10 à quelque 100 µm de matériau de base (2) correspondant.

7. Carte de circuits imprimés multifonctionnelle (1) selon l'une des revendications 1 à 6, **caractérisée en ce que** l'élément flexible est conducteur.

8. Carte de circuits imprimés multifonctionnelle (1) selon l'une des revendications 1 à 6, **caractérisée en ce que** l'élément flexible est conçu pour être isolant.

9. Carte de circuits imprimés multifonctionnelle (1) selon l'une des revendications 1 à 8, **caractérisée en ce que** l'élément flexible est conçu pour être dissipateur de chaleur.

10. Procédé pour produire une carte de circuits imprimés multifonctionnelle (1) avec au moins un élément fonctionnel supplémentaire (3), étant précisé que dans la zone de l'élément fonctionnel (3) est disposé au moins un rainurage (21, 22) et que ladite carte (1) est flexible dans cette zone, **caractérisé en ce que** l'élément ou les éléments fonctionnels (3) sont fixés au moins par morceaux, à plat, par ultrasons ou par soudage par friction, sous la forme d'une liaison intermétallique (6) avec un film de cuivre (4, 5, 10, 11, 12) dans une couche intérieure (7) de la carte de circuits imprimés (1).

11. Utilisation d'une carte de circuits imprimés multifonctionnelle (1) avec au moins un élément fonctionnel supplémentaire (3) selon l'une des revendications 1 à 9, comme carte de circuits imprimés rigide-flexible.

12. Utilisation selon la revendication 11, **caractérisée en ce que** l'élément flexible est utilisé comme surface de refroidissement.

13. Utilisation selon l'une des revendications 11 ou 12, **caractérisée en ce que** l'élément flexible est utilisé comme conducteur.

14. Utilisation selon l'une des revendications 11 ou 13, **caractérisée en ce que** l'élément flexible est utilisé comme conducteur de courant fort.
